# EUROPEAN PATENT SPECIFICATION

(11) **EP 3 046 108 B1**
(45) Date of publication and mention of the grant of the patent: **26.09.2018**
(21) Application number: 15198090.1
(22) Date of filing: 04.12.2015
(51) Int. Cl.: G11B 33/14

(54) **MODULAR DUCTING SOLUTION**
MODULARE LEITUNGSLÖSUNG
SOLUTION DE GAINES MODULAIRES

(30) Priority: 04.12.2014 GB 201421610
(43) Date of publication of application: 20.07.2016
(60) Divisional application: 18186427.3
(73) Proprietor: Nidec Control Techniques Limited, Newtown, Powys SY16 3BE (GB)
(72) Inventor: GIBSON, Richard Samuel, Newtown, Powys SY16 3BE (GB); WHITE, Jonathan Holman, Newtown, Powys SY16 3BE (GB); WILLIAMS, Robert Gwyn, Newtown, Powys SY16 3BE (GB)
(74) Representative: Harden, Henry Simon

(56) References cited:
- US-A1- 2006 048 001
- US-A1- 2007 025 076
- US-A1- 2009 103 414
- US-A1- 2012 243 170
- US-A1- 2013 258 580
- US-B1- 8 374 731

## Description

### Field of the invention

The present invention relates to the mounting of electrical components. In particular, but not exclusively, the present invention relates to the management of heat in rack-mounted arrays of drives, such as servo drives.

### Background to the invention

Servo- and other types of drives are commonly mounted vertically as well as horizontally to create banks of drives (e.g. data servers or supercomputers). Hot air from the lower drives rises up through the bank and heats the drives in the rows above. This can have a negative effect on the rating of components, limiting their performance.

Arrangements exist for cooling banks of drives, such as convective cooling, or forcing cooling air through the bank of drives by means of fans. Such cooling systems are often integrated into the cabinets which house the banks. However, such cooling systems require specialist equipment, and can be expensive to maintain and install. There is therefore a need for simple and inexpensive methods for cooling vertical banks of drives which can be integrated into existing cabinets and drives without modification.

US 2012/243170A1 discloses a system for storing data which includes a rack, one or more data storage modules coupled to the rack, and one or more data control modules coupled to the rack. The data storage modules may include a chassis, two or more backplanes coupled to the chassis, and one or more mass storage devices (for example, hard disk drives) coupled to the backplanes. The data control modules may access the mass storage devices in the data storage modules.

US 2007/0025076 A1 discloses a disk array apparatus for achieving installation of disk drives at high density, as well as a large capacity and a high speed of the disk array apparatus. The disk array apparatus comprises disk drives, a box containing a large number of the disk drives in a direction of thickness thereof, wherein a throttle of flow passage is provided above the disk drives in the downstream side of the disk array apparatus.

US 2013/0258580A1 discloses a storage apparatus including: a backplane having first and second faces; a first storage device and a first unit attached to the first face; a second storage device and a second unit attached to the second face; at least one first air-flow generator that generates air flow passing through, in sequence, the first storage device and the second unit; at least one second air-flow generator that generates air flow passing through, in sequence, the first unit and the second storage device; and a partition board, being interposed between the first and the second storage devices, that includes a first partition-board opening through which the first storage device communicates with the second unit and an inhibitor that prevents the air flow passing through the first storage device from flowing into the second storage device.

US 2009/0103414 A1 discloses an enclosure for a high-density storage system, comprising a backplane to which a plurality of data storage devices may be coupled, a front panel opposite the backplane and defining a first airflow channel adjacent a front side of the data storage devices, a back panel opposite the front panel and comprising a second airflow channel adjacent the backplane, a floor panel and a top panel, a first side panel comprising an array of airflow inlets, a second side panel comprising at least one air flow outlet, and a fan assembly to expel air from the at least one air outlet.

US 8374731 B1 discloses a cooling system including at least three fan units. A control unit operates each one of the at least three fan units, The control unit (a) operates only a selected two of the fan units, one of the at least three fan units being unselected and being inhibited from operation; (b) monitors operation of said selected two of fan units for a failure; and (c) upon detection of a failure in one of said selected two fan units, inhibits operation of the failed one of fan units and operating the unselected one of the at least three fan units.

US 2006/0048001 A1 discloses a storage subsystem connected to an external device and comprising a storage device arrangement portion, on which a plurality of storage devices is arranged, and a control device that controls communications between the plurality of storage devices arranged on the storage device arrangement portion and the external device. The storage device arrangement portion is constituted such that the plurality of storage devices is arranged upright in the directions of two dimensions.

### Summary of the invention

The present invention is set out on in the independent claims, with some optional features set out in the claims dependent thereto.

There is disclosed a drive apparatus, comprising:
a ducting piece comprising a base face, a top face opposite the base face, first and second end faces opposite to each other and adjacent to the base face, and attachment means, wherein the top face is closed and the base face is at least partially open, and wherein at least one of the first and second end faces is at least partially open; and a drive comprising an air vent and fixing means, wherein the attachment means of the ducting piece is coupled to the fixing means of the drive such that the at least partially open base face of the ducting piece is arranged to cover the air vent of the drive.

The apparatus can be mounted in a bank, whilst at the same time preventing hot air expelled from the vent of the drive rising and heating drives higher up in the bank. The base face of the ducting piece is arranged over the vent of the drive, whilst the top face opposite this base face is closed. Therefore, the hot air which is expelled through the vent enters the ducting piece and is diverted sideways through at least one of the at least partially open first and second end faces of the ducting piece. This prevents the hot air rising vertically through the bank of drives and thus improves the rating of the drives. The ducting piece could be manufactured with a variety of cross sections. The choice of cross section could allow wiring to be located along the top of the drive. The present disclosure is also advantageous as the length of the ducting piece (as measured between the two end faces) can be altered to suit the size of the drive it is coupled to. This allows users to cheaply and easily change between different size drives and/or ducting piece cross section, without the cost of reconfiguring an expensive cooling system.

Preferably, both the first and second end faces are partially open. This allows air to be diverted away from the drive in two directions. Furthermore, in preferred embodiments both the first and second end faces are fully open. This architecture ensures that the maximum air flow away from the drive is achieved for the smallest ducting piece.

Preferably, the attachment means of the ducting piece is click-fit coupled to the fixing means of the drive. This architecture means the ducting piece can be quickly and easily changed over, without the need for specialist tools or equipment.

A configurable drive and air duct system comprises a plurality of drive apparatuses, wherein at least one of the first and second end faces of each ducting piece is connected to a first or second end face of an adjacent ducting piece. When the drives are aligned in rows, ducting pieces of adjacent drives can be connected to one another along the row. This allows hot air expelled from the vents of each of the drives to travel sideways along the row of drives and to be expelled at the end of the row. This architecture reduces the hot air rising vertically through the bank of drives, and allows drives to be stacked vertically without affecting their performance.

Air is extracted from either or both ends of the air duct system. Also preferably, a blanking plate can be used to restrict airflow in one direction. In a preferred embodiment, there is a duct extension to facilitate removal of heat from the system. One end of the duct extension is suitable for connection to a first or second end face of a ducting piece. An additional end of the duct extension can be suitable for attachment to another device suitable for aiding the movement of air, for example an extraction hose or a fan.

All of these embodiments allow the drive and air duct system to be customised to suit the current equipment and set up of the individual user. This makes the drive and air duct system of the present disclosure truly modular and user configurable; it can also be integrated to current banks of drives for little cost and without extensive modification to existing equipment.

In a preferred embodiment, a fan is provided to encourage airflow through the ducting pieces. The fan may be provided in a ducting piece or in the duct extension, for example. This architecture can increase the efficiency with which hot air is expelled from the ducting system, without the need for integrating external fan systems with the present invention.

The system further comprises a cabinet in which the plurality of apparatus are mounted, wherein an airflow path formed at least in part by the ducting pieces extends to a hole in a wall of the cabinet. This allows the heat to be removed from the housing in which the drives are located.

Also disclosed is a drive system comprising:
a drive comprising an air vent; and
a backplane coupled to the drive, wherein a hole is provided in the backplane adjacent to the air vent.

The drive system can be mounted in a bank and housed in a cabinet. In this disclosure, heat generated in the drive is expelled through a vent at the rear of the drive. As the drive is mounted on the backplane, a corresponding hole is formed in the backplane so that the expelled heat is not prevented from leaving the drive by the backplane.

Preferably, the drive system comprises one or more further drives coupled to the backplane, wherein the drives comprise air vents, and wherein one or more further holes are provided in the backplane adjacent to the or each further air vent. This allows a plurality of drives to be mounted in a bank, whilst all being able to expel heat rearwards through the vent.

Preferably, the system also comprises one or more ducting pieces, wherein each ducting piece extends from an air vent through an adjacent hole. In some examples, the system further comprises a cabinet in which the backplane is mounted, and each ducting piece extends from the air vent to a hole provided in the cabinet. Preferred ducting pieces comprise an at least partially open base face, an at least partially open top face opposite to the base face, and closed side faces adjacent to the base face and the top face. A ducting piece may be disposed through each hole of the backplane, such that the at least partially open base face is arranged to cover the air vent of each drive. The ducting piece can ensure that the heat is expelled from the cabinet housing the drives and backplanes by forming a channel which extends rearward from the drive to the outside of the cabinet.

### Brief description of the drawings

Preferred embodiments of the present invention will now be described with reference to the accompanying drawings, in which:
Figure 1 shows schematically the arrangement of drives in a bank as in the prior art and the subsequent heat flow;
Figure 2 illustrates the arrangement of the drive and the ducting piece;
Figure 3 illustrates the arrangement of a plurality of the drive apparatuses;
Figure 4 shows schematically the arrangement of drives in a bank and the subsequent heat flow when a plurality of the drive apparatus are employed in the bank of drives;
Figure 5 illustrates a plurality of drive apparatuses;
Figure 6 shows a side view of an example of the drive apparatus of the present disclosure;
Figure 7 shows an alternative view of the example of the present disclosure; and
Figure 8 shows a side view of an example of the present disclosure.

### Detailed Description

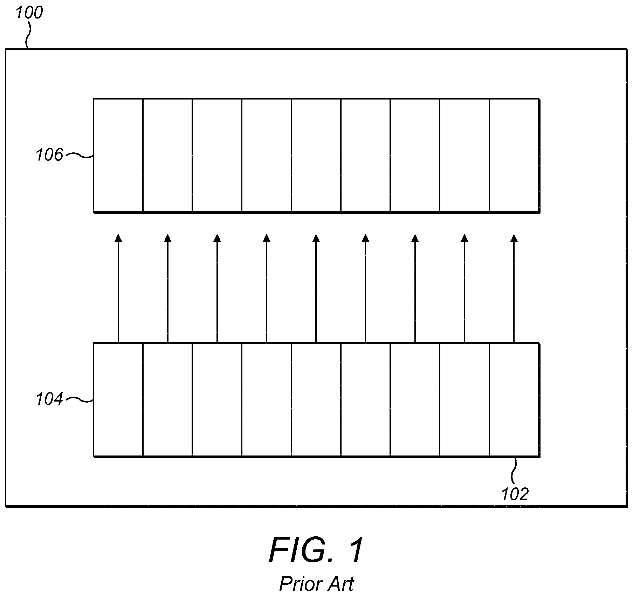

Referring to Figure 1, there is shown a plurality of drives according to the arrangement of drives 102 in the prior art. The drives 102 are arranged in horizontal rows (e.g. 104 and 106), with a plurality of horizontal rows stacked vertically in a bank 100. In this instance, the drives 102 are servo drives, although alternative drives could be used. The heat generated from the servo drives 102 in the lower row 104 rises up and heats the servo drives 102 in the upper row 106. The heat is illustrated in Figure 1 by the arrows pointing vertically from the lower row of servo drives 104 to the upper row 106. As the servo drives 102 in the upper bank 106 become hotter due to the warmer ambient temperature, the components could overheat and the rating of the servo drives 102 will be reduced compared to those in the lower bank 104. Energy is then required to cool the ambient temperature and prevent overheating of components.

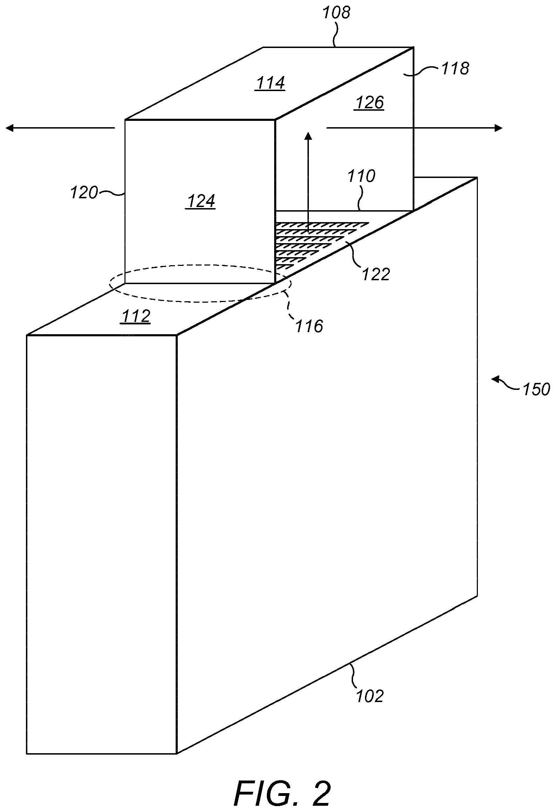

The apparatus 150 is shown in Figure 2. A servo drive 102 is an electronic amplifier used to power a servomechanism, or servo. A servo is a device which controls a mechanism by sensing the error between a given input and the response of the mechanism, and adjusting the mechanism accordingly. The servo drive 102 in this embodiment is substantially rectangular and suitable for stacking in horizontal rows, as illustrated in the rows 104 and 106 in Figure 1. A first surface 112 of the servo drive 102 comprises a vent 110 through which heat generated by the servo drive 102 can travel, as illustrated by the vertical arrow out of the vent 110 in Figure 2. The servo drive 112 also comprises fixing means (not shown in Figure 2). As discussed above, drives other than servo drives may be used, provided they have suitable fixing means.

The air ducting piece 108 comprises a base face 122, a top face 114 opposite to the base face 122 and first and second end faces (118 and 120) adjacent to the base face 122. There are also two other faces 124 and 126. Preferably, faces 124 and 126 are closed. The air ducting piece 108 also comprises attachment means (not shown in Figure 2). The first and second ends of the ducting piece 108 have a rectangular cross section, although alternative cross sectional geometries could be used.

In this embodiment, the base face 122, first end face 118, and second end face 120 are completely open, but in some embodiments the base face 122, the first end face 118, and the second end face 120 may be only partially open. In all embodiments, at least one of the first end face 118 and second end face 120 is at least partially open and is suitable for connection to an adjacent ducting piece. Two adjacent ducting pieces may connect with a click-fit mechanism, or may be mating parts. Other methods of connection between two adjacent ducting pieces may also be used. Preferably, an air tight seal is formed between adjacent ducting pieces.

The air ducting piece 108 may be formed of plastic or any other material suitable for formation into the desired geometry. Preferably, the air ducting piece 108 is formed of an insulating material, as such a material may optimise the prevention of heat rising from the lower banks of drives 104 to the upper bank 106. However, the air ducting piece 108 may also be formed of a non-insulating material such as a metal.

The attachment means of the air ducting piece 108 is arranged to couple to the fixing means of the servo drive 102 to create an attachment 116 between the servo drive 102 and the air ducting piece 108. In the preferred embodiment, the attachment means of the air ducting piece 108 couples to the fixing means of the servo drive 102 with a click-fit. This allows the air ducting piece 108 to be easily attached and detached from the servo drive 102. However, other means of attachment between the air ducting piece 108 and the servo drive 102 could be used. For example, the air ducting piece 108 could be attached to the servo drive 102 by means of a bolt or a screw. Preferably, the attachment 116 between the attachment means of the air ducting piece 108 and the fixing means of the servo drives 102 is air tight. The air ducting piece 108 attaches to the servo drive 102 such that the base face 122 of the air ducting drive covers the air vent 110.

Once the air ducting piece 108 is connected to the servo drive 102, heat generated during use of the servo drive 102 leaves the servo drive 102 through the air vent 110. The closed top face 114 of the air ducting piece 108 prevents the hot air from rising. Instead, the hot air is diverted sideways through the first and second end faces of the air ducting piece 108, as illustrated by the horizontal arrows in Figure 2.

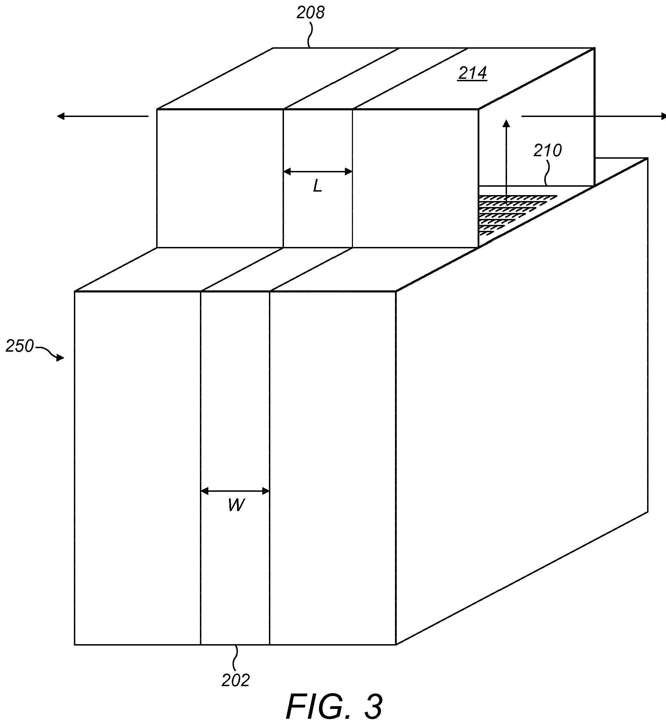

A plurality of apparatuses 150 shown in Figure 2 are connected to one another to form a system 250 of said apparatuses 150. This arrangement is illustrated in Figure 3. The servo drives 202 can be mounted adjacent to one another in rows 104. A plurality of adjacent air ducting pieces 208, each coupled to a servo drive 202, can be connected to one another. In the system 250, each ducting piece 208 has the same cross section. Each ducting piece 208 could have a varying cross section along the ducting piece, provided each ducting piece 208 is suitable for connection to an adjacent ducting piece. The width w of the servo drive 202 may vary. The length I of the air ducting piece 208, as measured between the first and second end faces, may also vary. For each apparatus 150 , the air ducting piece 108 is of a suitable length I for connection to a servo drive 102 of width w.

Where the system 250 comprises a plurality of the apparatus 150 of the present invention, each servo drive 202 can be of a different width w, and the corresponding air ducting piece 208 is chosen such that it is of suitable length I for connection to said servo drive 202. In this sense, the apparatus 150 is truly modular and user configurable; the size and geometry of the air ducting piece 108 can be chosen to suit the existing servo drive 102. When a plurality of apparatuses 150 are combined in a system 250, a user may configure the air ducting piece 208 to an existing servo drive 202, without having to replace the servo drive 202 to ensure that the width w is equal to the length I of the air ducting piece 208.

When there is a plurality of apparatuses 150 combined in a system 250, heat rises from the air vent 210 of each servo drive 202 and then is diverted by the closed top face 214 down the length of the ducting section formed of the plurality of air ducting pieces 208.

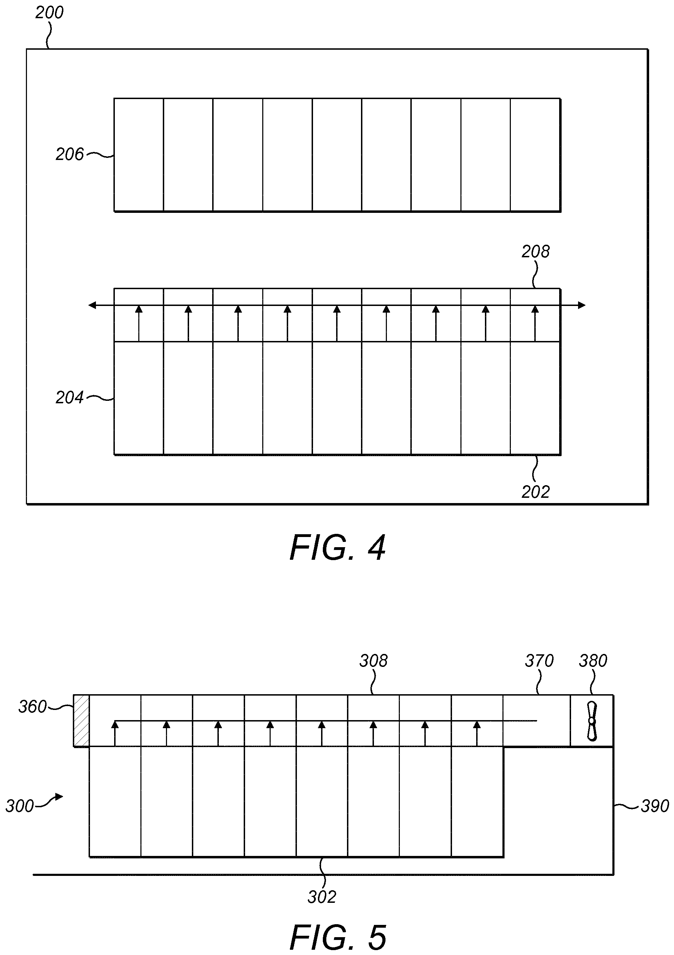

The system 250 shown in Figure 3 is further illustrated in Figure 4. Figure 4 shows a bank 200 containing a lower row 204 and an upper row 206 of servo drives 202. The lower row 204 of servo drives 202 also contains a plurality of air ducting pieces 208 coupled to the servo drives 202. As described above, the hot air is diverted down the ducting section formed of the plurality of air ducting pieces 208 and out the end faces of the end ducting pieces 208 of the lower row 204. The heat can then be extracted from the bank 200. Therefore, the heat does not rise and heat the servo drives in the upper row 206, thus preventing an increase in the power consumption of the servo drives 202 in the upper row 206 and a reduction in the rating of the servo drives 202.

Figure 5 shows a bank 300 of servo drives 302. The bank 300 also contains a plurality of ducting pieces 308 coupled to the servo drives 302. An additional blanking plate 360 is arranged to cover the at least partially open end face located at one end of the row of ducting pieces 308 in bank 300. The blanking plate 360 prevents heat exiting the row of ducting pieces 308 through said end face. A duct extension 370 is arranged to couple to the at least partially open end face located at the other end of the row of ducting pieces 308 in bank 300. Additionally, a fan 380 is included at the end of the duct extension 370 to improve heat extraction from the bank 300.

The duct extension 370 can have the same cross section as the plurality of ducting pieces 308, or can be of a varying cross section, provided at least one end face of the duct extension 370 is suitable for connection to an end face of a ducting piece 308. Alternatively, the duct extension 370 can be replaced with a plurality of ducting pieces 308 to extend the plurality of ducting pieces 308 to the edge of a cabinet 390, or outside of the cabinet 390. The cabinet 390 contains the plurality of drive apparatuses which form the bank 300. The duct extension 370 can be a single rigid piece of material, or a flexible pipe. Alternatively, the duct extension 370 can be formed of a plurality of pieces of material.

The fan 380 can be incorporated into the duct extension 370 or a ducting piece 308. The blanking plate 360, duct extension 370 and fan 380 can be arranged in combination with each other, or used in isolation. Alternatively, a plurality of blanking plates 360, duct extensions 370 and fans 380 can be arranged to modify the method of heat extraction to suit the equipment of the user.

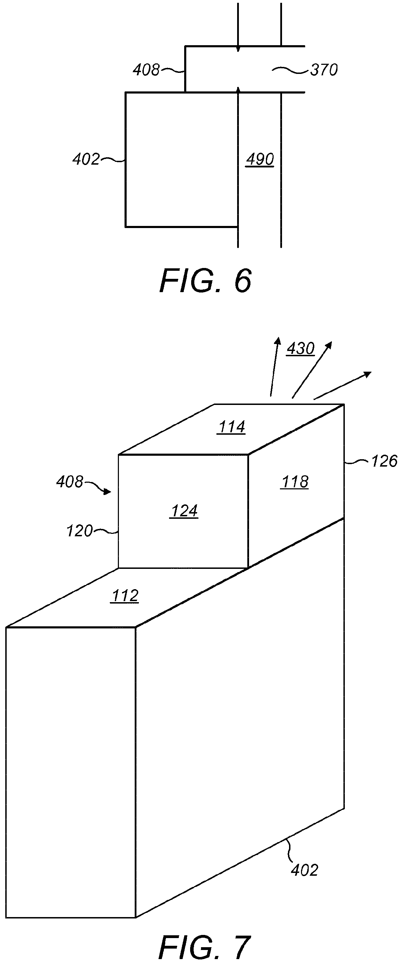

In an example, illustrated in Figure 6 and 7, face 126 is the at least partially open end face of the ducting piece 408, and faces 118 and 120 are closed.

References numbers of the features of the ducting piece 408 and servo drive 402 refer to those shown in Figure 2. In this embodiment, the ducting piece 408 is arranged such that the hot air 430 which exits the vent 110 on the surface 112 of the servo drive 402 exits the rear of the cabinet 490 which houses the drive apparatus, rather than the hot air being diverted to the side of the cabinet 490 as in Figure 4. A duct extension 370 can be used to bridge the gap between the air ducting piece 408 and the cabinet 490 if required.

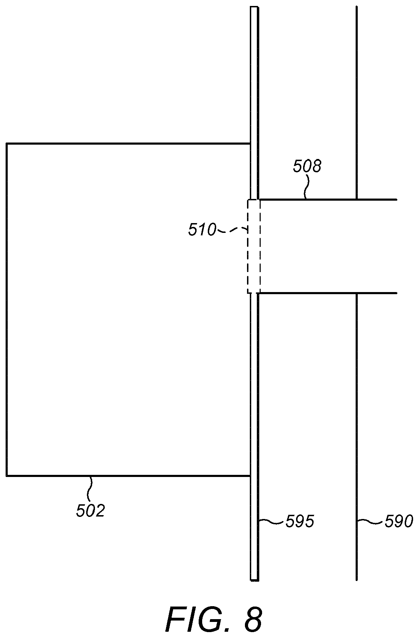

In an example of the present disclosure, illustrated in Figure 8, there is a drive 502. In this embodiment, the drive 502 is a servo drive. There is a vent 510 in the rear of the servo drive 502, through which the heat generated by the servo drive 502 is vented. There is a backplane 595 upon which the servo drive 502 is mounted. A backplane is a circuit board containing electrical connectors or sockets which other components can be connected to. The backplane 595 can formed such that it comprises a hole adjacent to each vent 510 of a servo drive 502 mounted upon it. The hole may be formed by drilling or in any other suitable manner. Preferably, the backplane 595 and servo drive 502 assembly are housed in a cabinet 590. A plurality of servo drives 502 can be mounted on the backplane 595. Furthermore, a plurality of backplanes 595 can be housed in the cabinet 590; the plurality of backplanes 595 can be arranged in rows in the cabinet 590, wherein each row is stacked vertically above another row.

In order to vent the hot air from the cabinet and prevent the servo drives 502 in the cabinet 590 from overheating as the expelled heat rises through the cabinet 590, a hole can be made in the cabinet. The backplane 595 can be arranged within the cabinet 590 such that the hole in the backplane 595 and the hole in the cabinet 590 line up. This ensures the vent 510 of the servo drive 502 is arranged to expel the hot air through the hole in the cabinet 590. Preferably, a ducting piece 508 can be employed to bridge the gap between the backplane 595 and the cabinet 590; the ducting piece 508 ensures more effective venting of the heat from the cabinet 590.

The ducting piece 508 can be attached to the cabinet 590, the backplane 595 or the servo drive 502. The ducting piece 508 can be attached to the servo drive 502 as in the embodiments described above. For example, the ducting piece 508 can comprise attachment means which-click fit couple to fixing means of the servo drive 502. Alternatively, the ducting piece 508 can be coupled to the servo drive 502 by means of bolts or screws.

In this example, the ducting piece 508 comprises an at least partially open base face, an at least partially open top face opposite to the base face, and side faces adjacent to the base face and top face. The ducting piece 508 can be of any cross section, provided the ducting piece 508 is suitable to cover the air vent 510 of the servo drive 502 and facilitate the expulsion of heat from the servo drive 502. In this example, the ducting piece 508 is of a rectangular cross section, but other geometries may be used.

The ducting piece 508 can be formed of the same materials as the ducting piece of the previous embodiments and examples. For example, the ducting piece 508 can be formed from an insulating or non-insulating material. The ducting piece 508 can be formed of a single rigid piece of material, or a flexible pipe. Alternatively, the ducting piece 508 can be formed of a plurality of pieces of material. An additional duct extension 370 could also be employed to bridge the gap between the hole in the backplane 595 and the hole in the cabinet 590.

Reference signs in the claims shall not be construed as limiting the scope of the claims. It should also be noted that the Figures are not necessarily to scale; emphasis instead generally being placed upon illustrating the principles of the present disclosure.

## Claims

1. A configurable drive air duct system (250) for a bank of drives, comprising:
a plurality of drive apparatus (150), each drive apparatus comprising:
a ducting piece (108) comprising a base face (122), a top face (114) opposite the base face, first (118) and second (120) end faces opposite to each other and adjacent to the base face, and side faces (124,126) opposite to each other and adjacent the base face, and attachment means, wherein the top face and side faces are closed and the base face is at least partially open, and wherein at least one of the first and second end faces is at least partially open; and
a drive (102) comprising an air vent (110) and fixing means, wherein the attachment means of the ducting piece is coupled to the fixing means of the drive such that the at least partially open base face of the ducting piece is arranged to cover the air vent of the drive, wherein the attachment means of the ducting piece is click-fit coupled to the fixing means of the drive, and
a cabinet (390) in which the plurality of apparatus are mounted,
wherein at least one of the first and second end faces of each ducting piece is connected to a first or second end face of an adjacent ducting piece,
wherein air is extracted from either or both ends of the air duct system, and
wherein an airflow path formed at least in part by the ducting pieces extends to a hole in a wall of the cabinet.

2. The apparatus of claim 1, wherein both the first and second end faces are partially open.

3. The apparatus of claim 1, wherein both the first and second end faces are fully open.

4. The system of claim 1, further comprising a blanking plate (360) to restrict air flow in one direction.

5. The system of claim 1 or 2, further comprising a duct extension (370) to remove heat from the system.

6. The system of any one of claims 1 to 5, further comprising a fan (380) arranged to encourage air flow through one or more ducting pieces.

## Patentansprüche

1. Konfigurierbares Antriebsluftkanalsystem (**250**) für eine Reihe von Antrieben, umfassend:
eine Vielzahl von Antriebsvorrichtungen (**150**), wobei jede Antriebsvorrichtung Folgendes umfasst:
ein Kanalstück (**108**), umfassend eine Grundfläche (**122**), eine obere Fläche (**114**), die der Grundfläche gegenüberliegt, erste (**118**) und zweite (**120**) Endflächen, die einander gegenüberliegen und an die Grundfläche angrenzen, und Seitenflächen (**124**, **126**), die einander gegenüberliegen und an die Grundfläche angrenzen, und Befestigungsmittel, wobei die obere Fläche und die Seitenflächen geschlossen sind und die Grundfläche mindestens teilweise offen ist, und wobei mindestens eine der ersten und zweiten Endflächen mindestens teilweise offen ist; und
einen Antrieb (**102**) mit einer Entlüftung (**110**) und Befestigungsmitteln, wobei die Befestigungsmittel des Kanalstücks mit den Befestigungsmitteln des Antriebs so gekoppelt sind, dass die zumindest teilweise offene Grundfläche des Kanalstücks so angeordnet ist, dass sie die Entlüftung des Antriebs abdeckt, wobei die Befestigungsmittel des Kanalstücks mit den Befestigungsmitteln des Antriebs einrastend gekoppelt sind, und
ein Gehäuse (**390**), in dem die Vielzahl von Geräten montiert ist,
wobei mindestens eine der ersten und zweiten Endflächen jedes Kanalstücks mit einer ersten oder zweiten Endfläche eines angrenzenden Kanalstücks verbunden ist,
wobei Luft von einem oder beiden Enden des Luftkanalsystems abgesaugt wird, und
wobei sich ein Luftstromweg, der sich zumindest teilweise durch die Kanalstücke bildet, zu einem Loch in einer Wand des Gehäuses erstreckt.

2. Vorrichtung nach Anspruch 1, wobei sowohl die erste als auch die zweite Endfläche teilweise offen sind.

3. Vorrichtung nach Anspruch 1, wobei sowohl die erste als auch die zweite Endfläche vollständig offen sind.

4. System nach Anspruch 1, ferner umfassend eine Abdeckplatte (**360**) zur Begrenzung des Luftstroms in eine Richtung.

5. System nach Anspruch 1 oder 2, ferner umfassend eine Kanalverlängerung (**370**) zum Abführen von Wärme aus dem System.

6. System nach einem der Ansprüche 1 bis 5, ferner umfassend ein Gebläse (**380**), das so angeordnet ist, dass es den Luftstrom durch ein oder mehrere Kanalstücke fördert.

## Revendications

1. Système de conduit d'air à entraînement configurable (250) pour un ensemble d'entraînements, comprenant :
une pluralité d'appareils d'entraînement (150), chaque appareil d'entraînement comprenant :
Une gaine (108) comprenant une face de base (122), une face supérieure (114) opposée à la face de base, une première (118) et une seconde (120) faces d'extrémité opposées l'une à l'autre et adjacentes à la face de base, et des faces latérales (124, 126) opposées l'une à l'autre et adjacentes à la face de base, et des moyens de fixation, la face supérieure et les faces latérales étant fermées et la face de base étant au moins partiellement ouverte, et au moins l'une des première et seconde faces d'extrémité étant au moins partiellement ouverte; et
un entraînement (102) comprenant un évent d'air (110) et des moyens de fixation, les moyens de fixation de la pièce de la gaine étant couplés aux moyens de fixation de l'entraînement de telle sorte que la face de base au moins partiellement ouverte de la gaine est agencée pour couvrir l'évent d'air de l'entraînement, les moyens de fixation de la gaine étant couplés par encliquetage aux moyens de fixation de l'entraînement, et
une armoire (390) dans laquelle la pluralité d'appareils sont montés,
au moins l'une des première et seconde faces d'extrémité de chaque gaine étant reliée à une première ou seconde face d'extrémité d'une gaine adjacente,
l'air étant extrait de l'une ou des deux extrémités du système de conduits d'air, et
un chemin d'écoulement d'air formé au moins en partie par les gaines s'étendant jusqu'à un trou dans une paroi de l'armoire.

2. Appareil selon la revendication 1, dans lequel la première et la seconde faces d'extrémité sont partiellement ouvertes.

3. Appareil selon la revendication 1, dans lequel la première et la seconde faces d'extrémité sont complètement ouvertes.

4. Système selon la revendication 1, comprenant en outre une plaque d'obturation (360) pour limiter l'écoulement d'air dans une direction.

5. Système selon la revendication 1 ou 2, comprenant en outre une extension de gaine (370) pour éliminer la chaleur du système.

6. Système selon l'une quelconque des revendications 1 à 5, comprenant en outre un ventilateur (380) agencé pour encourager l'écoulement de l'air à travers une ou plusieurs gaines.
